# EUROPEAN PATENT APPLICATION

(11) **EP 3 627 554 A1**
(43) Date of publication of application: **25.03.2020**
(21) Application number: 17910024.3
(22) Date of filing: 15.12.2017
(51) Int. Cl.: H01L 27/146, H01L 21/77

(54) **ARRAY SUBSTRATE AND MANUFACTURING METHOD THEREFOR, FLAT PANEL DETECTOR, AND IMAGING DEVICE**

(30) Priority: 19.05.2017 CN 201710362644
(71) Applicant: BOE Technology Group Co., Ltd., Beijing 100015 (CN); Beijing BOE Optoelectronics Technology Co., Ltd., Beijing 100176 (CN)
(72) Inventor: JIANG, Huigang, Beijing 100176 (CN); GAO, Jianjian, Beijing 100176 (CN); GUO, Haibo, Beijing 100176 (CN); ZHU, Xiaohui, Beijing 100176 (CN)
(74) Representative: Potter Clarkson
(86) International application number: PCT/CN2017/116523
(87) International publication number: WO 2018/209947

(57) **Abstract**

An array substrate is disclosed, which includes a base substrate, a low-temperature polysilicon thin film transistor disposed on the base substrate, and a photoelectric converter connected with a first electrode of the thin film transistor. The first electrode includes a first conductive layer, the photoelectric converter is disposed on a side of the first conductive layer facing away from the base substrate, and the first conductive layer includes a material resistant to etching in a process of forming the photoelectric converter. The first electrode is a source electrode or a drain electrode of the thin film transistor. Also disclosed are a method of manufacturing the array substrate, a flat panel detector including the array substrate, and an image apparatus including the flat panel detector.

## Description

### CROSS-REFERENCE TO RELATED APPLICATION

This application claims priority to Chinese Patent Application No. 20171036244.9 entitled "ARRAY SUBSTRATE, MANUFACTURING METHOD THEREOF, FLAT PANEL DETECTOR AND IMAGE APPARATUS "in the State Intellectual Property Office of China, the disclosure of which is hereby incorporated by reference in its entirety.

### TECHNICAL FIELD

The present disclosure relates to the field of photoelectric technology, more particularly, to an array substrate, a manufacturing method thereof, a flat panel detector and an image apparatus.

### DESCRIPTION OF THE RELATED ART

X-ray detection is widely used in the medical field. The X-ray passing through a target to be detected is usually detected by using a flat panel detection technology. The flat panel detection technology includes direct-type detection and indirect-type detection. A flat panel detector for achieving the indirect-type detection generally includes thin film transistors (TFTs) and photoelectric converters arranged in an array on an array substrate.

### SUMMARY

Embodiments of the present disclosure provide an array substrate, a manufacturing method thereof, a flat panel detector and an image apparatus.

According to one hand of the present disclosure, the array substrate is provided.

According to an exemplary embodiment, the array substrate, comprising: a base substrate; a thin film transistor on the base substrate; and a photoelectric converter connected to a first electrode of the thin film transistor, wherein the first electrode comprises a first conductive layer, the photoelectric converter is disposed on a side of the first conductive layer facing away from the base substrate, and the first conductive layer comprises a material resistant to etching in a process of forming the photoelectric converter, the first electrode is a source electrode or a drain electrode of the thin film transistor.

According to another embodiment, a material of the first conductive layer comprises at least one of indium tin oxide, indium zinc oxide, indium gallium zinc oxide, indium tin zinc oxide, indium gallium tin oxide, zinc oxide, cadmium oxide, and aluminum oxide.

According to another embodiment, the photoelectric converter further comprises a second conductive layer located on a second side of the photoelectric converter opposite to a first side, and the second conductive layer comprises metal material.

According to another embodiment, two ends of an active layer of the thin film transistor are respectively connected to the source electrode and the drain electrode of the thin film transistor, and an orthogonal projection of the active layer of the thin film transistor on the base substrate has a zigzag shape to lengthen a length between the two ends of the active layer.

According to another embodiment, the orthogonal projection of the active layer of the thin film transistor on the base substrate has a U shape, and the source electrode and the drain electrode of the thin film transistor are respectively connected to the two ends of the active layer.

According to another embodiment, the thin film transistor is a top-gate thin film transistor, the array substrate further comprises a second electrode connected to a transparent electrode layer, the transparent electrode layer being disposed on a surface of a side of the photoelectric converter facing away from the base substrate, an orthogonal projection of the second electrode on the base substrate and an orthographic projection of the active layer of the thin film transistor on the base substrate are spaced apart from each other.

According to another embodiment, the array substrate further comprises a buffer layer between the active layer of the thin film transistor and the base substrate.

According to another embodiment, the photoelectric converter is a photodiode.

According to another embodiment, the thin film transistor is a low-temperature polysilicon thin film transistor.

According to another hand of the present disclosure, the flat panel detector is provided.

According to an exemplary embodiment, the flat panel detector, comprising: the array substrate according to any one of above-mentioned embodiments , and a non-visible light conversion layer covering the array substrate, wherein the non-visible light conversion layer is configured to convert non-visible light into visible light, and the photoelectric converter converts the visible light into an electrical signal.

According to yet another hand of the present disclosure, an image apparatus comprising the flat panel detector is provided.

According to still yet another hand of the present disclosure, a method for manufacturing an array substrate is provided.

According to an exemplary embodiment, the method comprising the following steps: providing a base substrate; forming a thin film transistor disposed on the base substrate, wherein the step of forming a thin film transistor comprises forming a first conductive material layer and forming a first electrode of the thin film transistor from the first conductive material layer through a patterning process; and forming a photoelectric converter connected with the first electrode of the thin film transistor, wherein the first electrode comprises a first conductive layer, the photoelectric converter is disposed on a side of the first conductive layer facing away from the base substrate, and the first conductive layer comprises a material resistant to etching in a process of forming the photoelectric converter.

According to another embodiment, a material of the first conductive layer comprises at least one of indium tin oxide, indium zinc oxide, indium gallium zinc oxide, indium tin zinc oxide, indium gallium tin oxide, zinc oxide, cadmium oxide, and aluminum oxide.

According to another embodiment, the method further comprising: forming a first metal material layer before forming the first conductive material layer, wherein the first conductive material layer covers the first metal material layer, and the source electrode and the drain electrode of the thin film transistor are formed by implementing one patterning process on the first metal material and the first conductive material layer.

According to another embodiment, before forming the source electrode and the drain electrode, the method further comprises following steps: forming a polysilicon material layer on the base substrate; forming a U-shaped active layer through one patterning process; forming a gate insulating layer and a second metal material layer; and forming a gate electrode by performing one patterning process on the second metal material layer, wherein an orthogonal projection of the gate electrode on the base substrate and an orthogonal projection of the U-shaped active layer on the base substrate have an overlapping region.

According to another embodiment, after forming the photoelectric converter, the method further comprises following steps: forming a third metal material layer, and forming a second electrode connected to a transparent electrode layer through a patterning process, the transparent electrode layer being disposed on a surface of a side of the photoelectric converter facing away from the base substrate; wherein an orthogonal projection of the second electrode on the base substrate and an orthogonal projection of the active layer of the thin film transistor on the base substrate are spaced apart from each other.

According to another embodiment, before forming the active layer, the method further comprises: forming a buffer layer covering the base substrate on the base substrate.

### BRIEF DESCRIPTION OF THE DRAWINGS

Embodiments of the present disclosure will now be described by means of example with reference to the accompanying drawings,
FIG. 1 is a schematic structural view of an existing flat panel detector;
FIG. 2 is a schematic structural view of an array substrate according to an embodiment of the present disclosure;
FIG. 3 is a schematic structural view of a TFT and a photoelectric converter connected with the TFT in FIG. 2;
FIG. 4 shows an alternative embodiment of the embodiment shown in FIG 3;
FIG. 5 is a schematic structural view of a TFT and a photoelectric converter connected with the TFT according to another embodiment of the present disclosure, that is, an additional polarized electrode is arranged on the array substrate shown in FIG. 4 ;
FIG.6 is a schematic view of a shape of an active layer in a TFT according to one embodiment of the present disclosure;
FIG. 7 is a schematic structural view of an array substrate with the TFT structure shown along the B-B direction in FIG. 6;
FIG. 8 is a schematic structural view of a flat panel detector according to an embodiment of the present disclosure;
FIG. 9 is a flow chart of a manufacturing method of an array substrate according to another embodiment of the present disclosure;
FIGS. 10, 11a, 11b, 12, 13, 14, and 15 illustrate manufacturing steps of the array substrate shown in FIG. 7, respectively.

### DETAILED DESCRIPTION OF THE EMBODIMENTS

Exemplary embodiments of the present disclosure will be described in detail below with reference to the accompanying drawings. Like reference numerals in the drawings refer to like features. The present disclosure may also be implemented in other various forms, and thus the present disclosure should not be construed as being limited to the embodiments set forth herein. The purpose of providing these embodiments is to enable those skilled in the art to fully and completely understand the concept of the present disclosure.

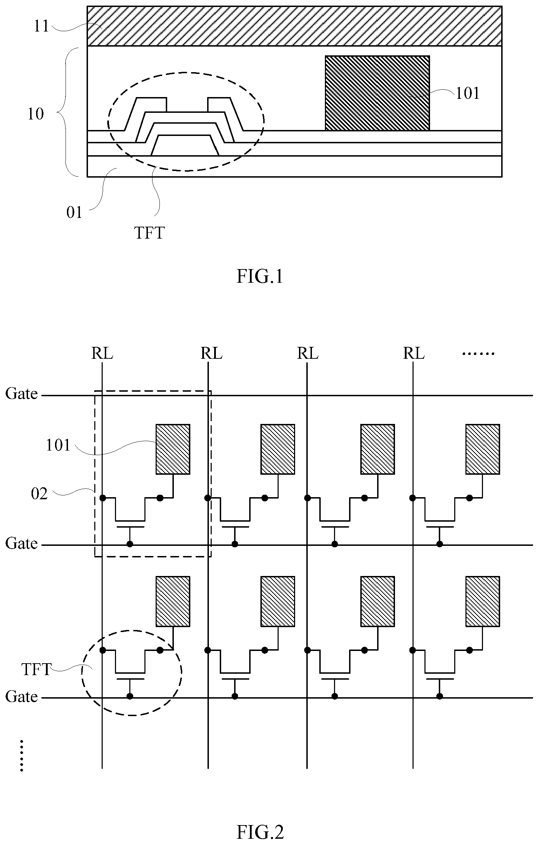

As shown in FIG. 1, a flat panel detector (FPD) for achieving indirect-type detection includes an array substrate 10 and a non-visible light (e.g. X-ray) conversion layer 11 covering the array substrate. The array substrate is provided with thin film transistors (TFTs) and photoelectric converters 101 arranged in an array. The X-ray conversion layer 11 converts non-visible light into visible light, and then the photoelectric converters 101 convert the visible light into electric signals and store them. When the TFTs connected to the photoelectric converters 101 are turned on, the electric signals are output to a processor and processed by the processor to obtain image information. At present, when the photoelectric converters are manufactured, the TFTs on the array substrate may be adversely affected, so that the conduction performance of the TFTs is deteriorated, thereby deteriorating the detection effect of the flat panel detector.

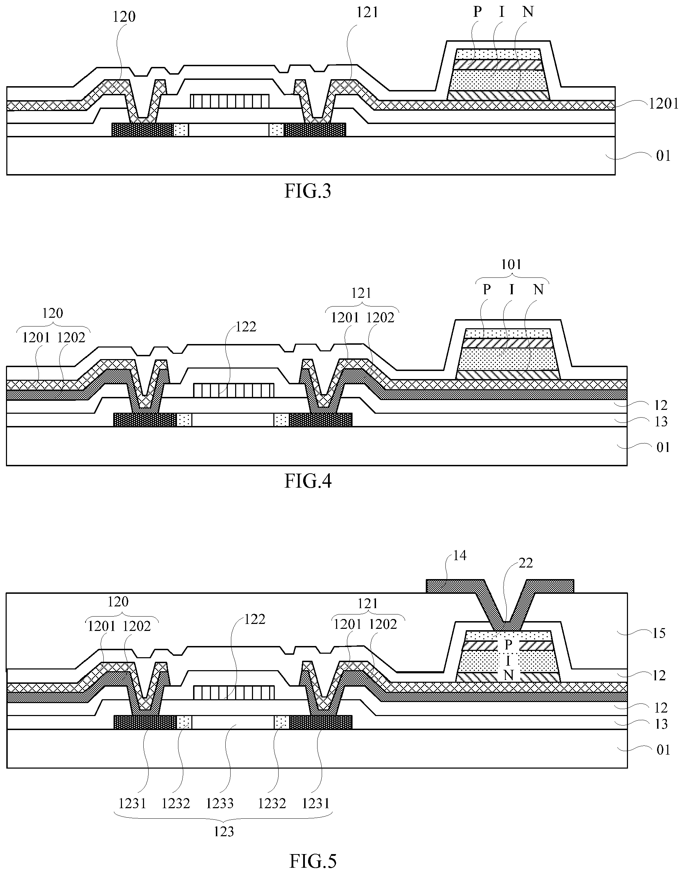

Still referring to FIG. 1, the present application provides an array substrate 10 which includes a base substrate 01, a plurality of thin film transistors (TFTs) arranged on the base substrate 01 in a matrix as shown in FIG. 2 and the photoelectric converters101 connected to first electrodes of the respective TFTs. The first electrode is a source electrode 120 or a drain electrode 121 of the TFT (refer to FIGS. 3 and 4).

As shown in FIG. 2, the array substrate 10 further includes a plurality of gate lines Gate and a plurality of read signal lines RL crossing each other. The gate lines Gate and the read signal lines RL crossing each other define a plurality of detection units 02 arranged in a matrix. Each of the detection units is provided with one low-temperature polysilicon TFT mentioned above and one photoelectric converter 101 connected with the TFT.

A gate electrode of each TFT is connected to the gate line Gate, and the drain electrode 121 (or the source electrode 120) of each TFT is connected to the read signal line RL. It can be understood that, when the source electrode 120 of the TFT is connected to the photoelectric converter 101, the drain electrode 121 of the TFT is connected to the read signal line RL; when the drain electrode 121 of the TFT is connected to the photoelectric converter 101, the source electrode 120 is connected to read signal line RL. For convenience of explanation, in each of the following embodiments or examples, as an example, the drain electrode 121 of the TFT is connected to the photoelectric converter 101, and the source electrode 120 of the TFT is connected to the read signal line RL.

In each of the embodiments of the present disclosure, the TFT may be an N-type TFT or a P-type TFT.

The photoelectric converter 101 may be a photoresistor, a phototransistor, a photodiode or a photoelectric coupler. In an exemplary embodiment, the photoelectric converter 101 is the photodiode. Specifically, the photodiode may have a PIN structure as shown in FIG. 3. The PIN structure includes: an N-type semiconductor material layer which is adjacent to the base substrate 01 and is formed of an N-type impurity-doped semiconductor material; a P-type semiconductor material layer which is formed away from the base substrate 01 and is formed of a P-type impurity-doped semiconductor material; and an I-type semiconductor material layer which is positioned between the N-type semiconductor material layer and the P-type semiconductor material layer and formed of a low-doped intrinsic semiconductor material.

In the case where the photoelectric converter 101 is a photodiode and the drain electrode 121 of the TFT is connected to the photoelectric converter 101, the N-type semiconductor material layer adjacent to the base substrate 01 in the photodiode is connected to the drain electrode 121 of the TFT.

The drain electrode 121 of the TFT is connected to the photoelectric converter. In an exemplary embodiment, as shown in FIG. 3, the drain electrode 121 includes a portion that extends into a region where the photoelectric converter 101 is located. In other words, the drain electrode 121 may be formed of a first conductive layer 1201, and the first conductive layer 1201 photoelectric converter 101 is formed on the first conductive layer 1201. Since the photoelectric converter is usually manufactured through a dry etching process, the first conductive layer 1201 needs to be formed of an etching-resistant material. That is, in the process of manufacturing the photoelectric converter 101, the etching process has no or little influence on the first conductive layer 1201.

It can be understood that, in an alternative embodiment not shown in the drawings, the photoelectric converter may also be connected to the source electrode of the TFT, and/or the photoelectric converter may also be formed on an extended portion of the source electrode of the TFT, and the source electrode of the TFT or its extended portion is formed of the etching-resistant material.

According to an exemplary embodiment, the material of the first conductive layer may be selected from at least one of the following oxide materials: indium tin oxide (ITO), indium zinc oxide (IZO), indium gallium zinc oxide (IGZO), indium tin zinc oxide (ITZO), indium gallium tin oxide (ITGO), zinc oxide (ZnO), cadmium oxide (CdO), or aluminum oxide (Al₂O₃) and the like.

Since the first conductive layer is formed of the etching-resistant material, when the photodiode is manufactured through the dry etching process, the ion beam or the plasma in the dry etching process has less influence on the first conductive layer 1201, thereby enabling the electrical properties of the TFTs located in different detection units 02 to be uniform, reducing the possibility of a defect of Mura due to the uneven electrical properties of the TFTs. In other embodiments, even if it is considered that the PIN photodiode is manufactured through a wet etching process, the material of the first conductive layer can be resistant to an etching action of an etching solution by selecting an appropriate etching solution formulation and the material of the first conductive layer.

Low-temperature polysilicon has good conductivity and electrical properties because of its high carrier mobility. In the case of using the low-temperature polysilicon to manufacture the TFT, the TFT can be controlled to turn on or turn off without making a line width of a signal line (i.e., the gate line Gate and the read signal line RL) connected to the TFT be large. Therefore, in the case of using a low-temperature polysilicon to manufacture the TFT, the line widths of the gate line Gate and the read signal line RL can be appropriately decreased. In this way, a light shielding area on the array substrate can be decreased, thereby increasing a light absorption area of each detection unit 02 in the array substrate, so that the detection units 02 may detect the light with higher accuracy.

In order to improve the conductivity of the source electrode 120 and the drain electrode 121 of the TFT, in one embodiment, as shown in FIG. 4, at least one of the source electrode 120 and the drain electrode 121 of the TFT may further include a second conductive layer 1202 which is located on a side of the first conductive layer 1201 opposite to the side where the photoelectric converter 101 is located. The material constituting the second conductive layer 1202 may include a metal material such as metal molybdenum (Mo), metal aluminum (Al), or molybdenum aluminum alloy (Al-Mo or Mo-Al-Mo).

In the case that both the source electrode 120 and the drain electrode 121 include the second conductive layer 1202 which is closer to the base substrate 01 than the first conductive layer 1201 and the first conductive layer 1201 which is closer to the photoelectric converter 101 than the second conductive layer 1202, a method of manufacturing the source electrode 120 and the drain electrode 121 may include: as shown in FIG. 4, depositing a metal material layer and a first conductive material layer on a passivation layer 12 formed on the base substrate 01 in sequence, then forming a pattern of the source electrode 120 and the drain electrode 121 through one patterning process.

It should be noted that in the present application, the patterning process may include performing steps such as photolithography, etching and the like on the material layer, and processes for forming a predetermined pattern, such as printing, ink jet, and the like. The patterning process may include processes of forming a pattern by using a photoresist, a mask plate, an exposure machine and the like, such as film formation, exposure, development and the like. The corresponding patterning process may be selected according to a specific structure in the present disclosure.

The terms "one patterning process" or "single patterning process" described in the present disclosure is to form different exposure regions by using one mask plate, develop the different exposure regions, and then perform one or more removal processes, such as etching, ashing and the like, eventually obtain a desired pattern.

Since the first conductive layer 1201 and the second conductive layer 1202 are made of different materials, it is necessary to use different etching solutions to etch the first conductive material layer, and then to etch the metal material layer. The appropriate etching solutions should be selected according to specific materials, so that an etching solution for etching the first conductive material layer has no influence on metal material layer, and an etching solution for etching the metal material layer has no influence on the first conductive material layer.

In addition, since the first conductive layer 1201 mainly composed of an oxide conductive material is in contact with the photoelectric converter 101 and the first conductive layer 1201 has good resistance to dry etching, in the process of manufacturing the photoelectric converter 101 by using the dry etching process, the first conductive layer 1201 may serve as a dry etching barrier layer to protect the second conductive layer 1202 mainly composed of a metal material, so as to avoid the ion beam or plasma in the dry etching process from damaging the second conductive layer 1202 . Thus, conduction performances of the source electrodes 120 and the drain electrodes 121 of the TFTs located in the different detection units 02 are uniform, thereby reducing the probability of the defect of Mura due to the different conduction performances of the source electrodes and the drain electrodes of the TFTs.

The low-temperature polysilicon TFT described above may be a bottom-gate type TFT or a top-gate type TFT. In an exemplary embodiment, the abovementioned TFT is a top-gate type TFT as shown in FIG. 3 or FIG. 4.

Specifically, as shown in FIG. 5, the top-gate type low-temperature polysilicon TFT includes an active layer 123, a gate insulating layer 13, a passivation layer 12 and a gate electrode 122which are sequentially adjacent to the base substrate 01. The active layer 123 includes a channel region 1233, lightly doped regions 1232 adjacent to both sides of the gate electrode 122, and heavily doped regions 1231 located on a side of each lightly doped region 1232. An orthogonal projection of the channel region 1233 on the base substrate 01 corresponds to a position of an orthogonal projection of the gate electrode 122 on the base substrate 01. The source electrode 120 and the drain electrode 121 are respectively connected to the heavily doped regions 1231 on the active layer 123 through via holes located in the passivation layer 12 and the gate insulating layer 13. When the top-gate TFT is turned on, the gate electrode122 may shield the channel region 1233 to prevent the incident light from irradiating the channel region 1233, which may otherwise increase the leakage current of the TFT and adversely affect the electrical characteristics of the TFT.

In the embodiment shown in FIG. 5, the array substrate 10 further includes an electrode 14. In this case, since the gate electrode 122 may shield the channel region 1233, it is not necessary to shield the channel region 1233 of the TFT by using the electrode 14 as a light shielding layer. As shown in FIG. 5, the electrode 14 is connected to a transparent electrode layer 22 disposed on a side surface of the photoelectric converter 101 facing away from the base substrate 01 (i.e., a P-type semiconductor material layer in FIG. 5). An orthogonal projection of the electrode 14 on the base substrate 01 does not overlap an orthogonal projection of the active layer 123 of the TFT on the base substrate 01. In this way, an area of the electrode 14 may be reduced, so that an area of the light shielding region on the array substrate may be reduced, and a light absorption area of each detection unit 02 may be increased.

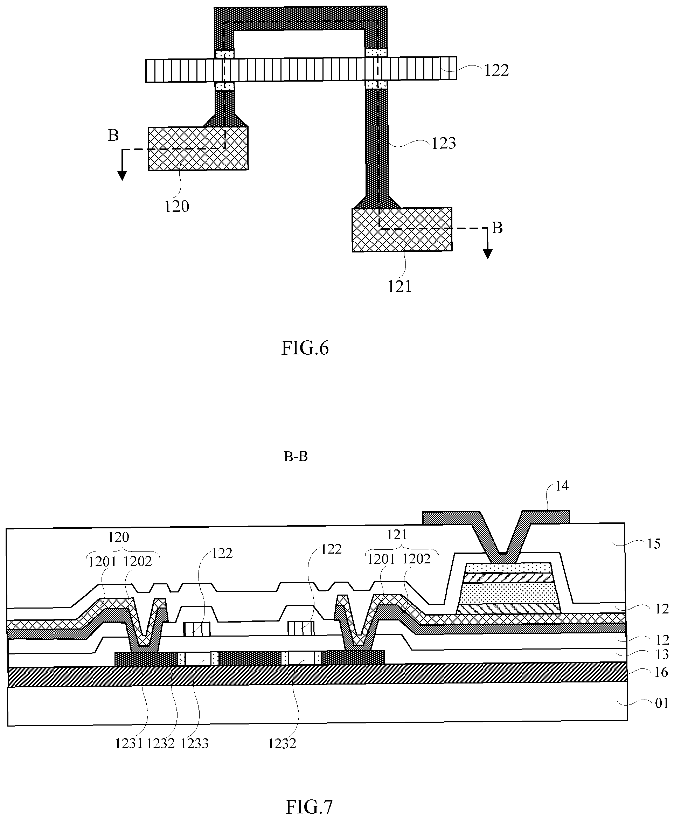

Since the low-temperature polysilicon TFT has higher carrier mobility than an amorphous silicon TFT, when the low-temperature polysilicon TFT is turned on, the number of carriers generated in the active layer 123 is large. In order to reduce an impact on the drain electrode 121 or the source electrode 120 when the carriers are transferred from the source electrode 120 (or the drain electrode 121) to the drain electrode 121 (or the source electrode 120), in an exemplary embodiment, when viewed in a plan view, as shown in FIG. 6, a pattern of the active layer 123 of the low-temperature polysilicon TFT (or the shape of the orthogonal projection of the active layer 123 on the base substrate) is set to a U-shape, and the source electrode 120 and the drain electrode 121 of the TFT are respectively connected to both ends of the active layer 123.

In addition, a pattern of the gate electrode 122 of the TFT is in a strip shape. The strip-shaped pattern overlaps two legs of the U-shaped pattern (two vertical portions of the active layer 123, as shown in FIG. 6), respectively, and is parallel to a middle portion (a horizontal portion of the active layer 123, as shown in FIG. 6) of the U-shaped pattern. In this way, when the TFT is turned on, the U-shaped active layer 123 may enlarge a migration path of carriers, so that a larger number of carriers can be buffered and the impact of carriers on the drain electrode 121 or the source electrode 120 is reduced when carriers are transferred from the source electrode 120 (or the drain electrode 121) to the drain electrode 121 (or the source electrode 120).

FIG. 7 is a schematic structural view of a top-gate type low-temperature polysilicon TFT shown in the B-B direction in FIG 6.

As shown in FIG. 7, the TFT is a top-gate low-temperature polysilicon TFT, and the array substrate 10 further includes a buffer layer 16 between the active layer 123 of the TFT and the base substrate 01. The buffer layer 16 may reduce in the influence of impurities in the base substrate 01 (for example, a glass substrate) on the active layer 123, thereby facilitating the improvement of electrical properties of the TFT.

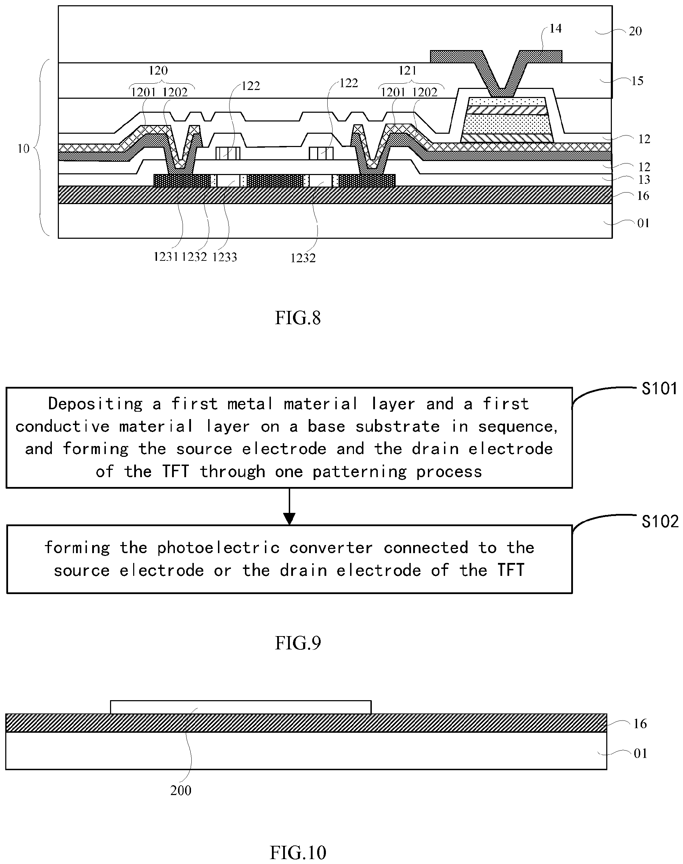

An embodiment of the present application provides a detector. As shown in FIG. 8, the detector is, for example, a flat panel detector, which includes, for example, the array substrate 10 shown in FIG. 7, and the non-visible light conversion layer 20 covering the array substrate 10. The non-visible light conversion layer 20, for example, may include a scintillator such as cesium iodide (CsI) or gadolinium oxysulfide (Gd₂O₂S) for converting invisible light (for example, X-ray, infrared, and ultraviolet rays, etc.) into visible light. In this case, the photoelectric converter 101 on the array substrate 10 may collect visible light irradiating each detection unit 02. In addition, the flat panel detector may further include an image processor for receiving the above collection result and obtaining a collection image according to the collection result of each detection unit 02 .

The flat panel detector according to the embodiment of the present disclosure may be used in various fields such as, but not limited to: medical care, safety, non-destructive detection, scientific research, and the like.

An embodiment of the present disclosure provides an image apparatus including the flat panel detector as described above. The image apparatus may also include an image analysis component for analyzing the collection image acquired by the flat panel detector and obtaining an analysis result for use or reference by the technicians.

According to another aspect of the present disclosure, a method of manufacturing an array substrate is also provided. According to an exemplary embodiment, a first conductive material layer is deposited on a base substrate, and a source electrode and a drain electrode of the TFT are formed through one patterning process.

In another embodiment, as shown in FIG. 9, the method includes step S101: depositing a first metal material layer and a first conductive material layer on a base substrate 01 in sequence, and forming the source electrode 120 and the drain electrode 121 of the TFT shown in FIG. 4 through a first patterning process. That is, the first metal material layer is formed before the first conductive material layer is formed, so that the first conductive material layer may cover the first metal material layer. Specifically, in step S101, exposure and development may be performed through one patterning process, then the first conductive material layer and the first metal material layer are etched by different etching solutions, and finally the photoresist is peeled off, thereby forming the source electrode 120 or the drain electrode 121 of the TFT.

In an exemplary embodiment, each of the source electrode 120 and the drain electrode 121 includes a first conductive layer 1201 and a second conductive layer 1202. The first conductive layer 1201 is made of the first conductive material layer described above, and the second conductive layer 1202 is made of the first metal material described above. The first metal material may be metal molybdenum (Mo), metal aluminum (Al), or molybdenum aluminum alloy (Al-Mo or Mo-Al-Mo).

In addition, the method may further include step S102: forming a photoelectric converter 101 connected to the source electrode 120 or the drain electrode 121 of the TFT through a patterning process.

When the abovementioned photoelectric converter 101 (for example, a photodiode) is manufactured by dry etching, since the first conductive layer 1201 has good resistance to dry etching, the first conductive layer 1201 may protect the second conductive layer 1202 mainly composed of a metal material, so as to avoid the ion beam or plasma in the dry etching process from damaging the second conductive layer 1202. Thus, conduction performances of the source electrodes 120 and the drain electrodes 121 of the TFTs located in the different detection units 02 are uniform, thereby reducing the probability of the defect of Mura due to the different conduction performances of the source electrodes and the drain electrodes of the TFTs.

In one embodiment, the TFT is a top-gate type low-temperature polysilicon TFT, and a shape of an active layer 123 and a shape of a gate electrode 122 is shown in FIG. 6, and the method for manufacturing the TFT according to this embodiment will be described in detail below.

In a first step, as shown in FIG. 10, a buffer layer 16 and a polysilicon thin film layer sequentially covering the base substrate 01 are formed on the base substrate 01, and a first patterning process is performed on the polysilicon (P-Si) thin film layer, then a pattern of the polysilicon film 200 is formed through a dry etching process and a peeing-off process. The polysilicon film pattern has U-shape as shown in FIG. 6.

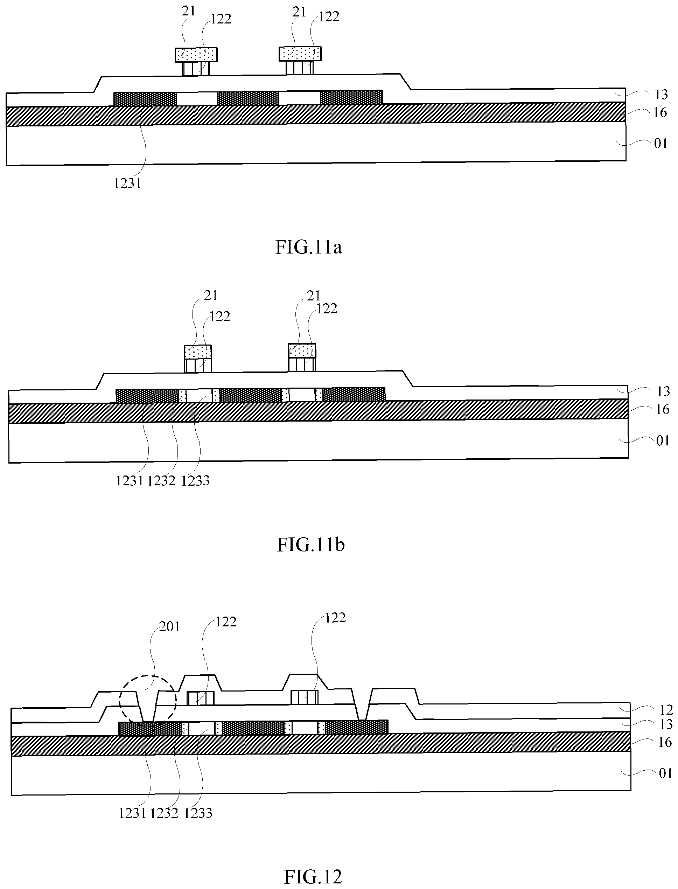

In a second step, as shown in FIG. 11a, on the buffer layer 16 and the polysilicon film 200, the gate insulating layer 13 and the second metal material layer covering the polysilicon film pattern are sequentially deposited; and a second patterning process is performed on the second metal material layer; then a pattern of the strip-shaped gate electrode 122 as shown in FIG. 6 and a remaining portion of a photoresist 21 covering the gate electrode 122 are formed by a wet etching process. A width of the remaining portion of the photoresist 21 is greater than that of the gate electrode 122. The pattern of the strip-shaped gate 122 overlaps respectively two legs of the pattern of a U-shaped polysilicon film 200 and is parallel to a middle portion of the U-shaped pattern.

Then, by using the gate electrode 122 and the photoresist 21 over the gate electrode 122 as a mask, the polysilicon film 200 is heavily doped (for example, nitrogen doped) through the gate insulating layer 13 to form a heavily doped region 1231. Then, as shown in FIG. 11 b, the remaining photoresist 21 is ashed to remove a portion of the photoresist 21 extending beyond both sides of the gate electrode 122. By using the gate electrode 122 and the photoresist 21 on the gate electrode 122 as a mask, the polysilicon film 200 is lightly doped to form a lightly doped region 1232 and a channel region 1233; the photoresist 21on the gate electrode 122 is then peeled off through a peeling-off process. Thus, a TFT in a shape as shown in FIG. 6, which has the U-shaped active layer 123 and the strip-shaped gate electrode 122 can be obtained.

In a third step, a passivation layer 12 is deposited on a structure finally obtained in the second step; and a third patterning process is performed on the passivation layer 12, and then a first via hole 201 as shown in FIG. 12 is formed in the passivation layer 12 and the gate insulating layer 13 through the dry etching process and the peeling-off process.

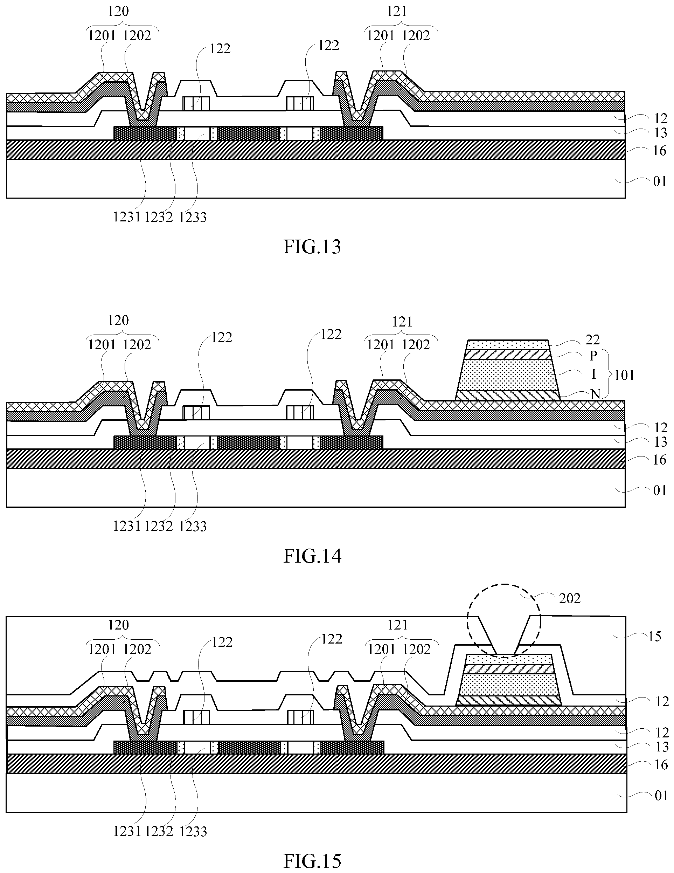

In a fourth step, on a structure shown in FIG. 12, the above-mentioned step S101 is performed to form the source electrode 120 and the drain electrode 121 of the TFT shown in FIG. 13, the source electrode 120 and the drain electrode 121 are connected to the heavily doped region 1231 of the active layer 123 through the first via holes 201. The patterning process employed in step S101 may be referred to as a fourth patterning process.

In a fifth step, on a structure shown in FIG. 13, a P-type semiconductor material layer, an I-type semiconductor material layer, an N-type semiconductor material layer, and a transparent electrode layer 22 are deposited in this order; and a fifth patterning process is performed on the above-mentioned four thin film layers. Then, a wet etching process is performed on the transparent electrode layer 22, and the dry etching process is performed on the P-type semiconductor material layer, the I-type semiconductor material layer, and the N-type semiconductor material layer. Finally, the photoresist is peeled off by the peeling off process to form a photoelectric converter 101 and a transparent electrode layer 22 located on the photoelectric converter 101 as shown in FIG. 14. In an exemplary embodiment, the material for forming the above-mentioned transparent electrode layer 22 includes a transparent conductive material such as ITO, IZO, IGZO, or the like.

Since the first conductive layer 1201 has good resistance to dry etching, during the dry etching process of the abovementioned three semiconductor material layers (i.e., P-type semiconductor material layer, I-type semiconductor material layer, and N-type semiconductor material layer), the first conductive layer 1201 may protect the second conductive layer 1202 mainly composed of a metal material, so as to avoid the ion beam or plasma in the dry etching process from damaging the second conductive layer 1202 . Thus, conduction performances of the source electrodes 120 and the drain electrodes 121 of the TFTs located in the different detection units 02 are uniform, thereby reducing the probability of the defect of Mura due to the different conduction performances of the source electrodes and the drain electrodes of the TFTs.

In a sixth step, as shown in FIG. 14, a passivation layer 12 and a resin layer 15 are deposited, and a sixth patterning process is performed on the passivation layer 12 and the resin layer 15, followed by a dry etching process and a peeling off process. A second via hole 202 is formed in both the passivation layer 12 and the resin layer 15 at a position corresponding to the transparent electrode layer 22, thereby forming a structure shown in FIG. 15.

In a seventh step, on the structure as shown in FIG. 15 , a third metal material layer is deposited; and a seventh patterning process is performed on the third metal material layer, and then a wet etching process and a peeling off process are performed to form the electrode 14 as shown FIG. 8. The electrode 14 is connected to the transparent electrode layer 22, which is disposed on a side of the photoelectric converter 101 facing away from the base substrate 01, through the second via hole 202. The electrode 14 is used to supply the transparent electrode layer 22 with a power supply voltage.

In order to increase the light absorption area of each detection unit 02, the electrode 14 is configured to have the orthogonal projection on the base substrate 01 which does not overlap the orthogonal projection of the active layer 123 of the TFT on the base substrate 01.

It should be noted that the materials which respectively constitute the first metal material layer, the second metal material layer, and the third metal material layer may be the same or different.

From the foregoing descriptions, it can be understood that the method for manufacturing the array substrate provided by the present disclosure uses a total of seven patterning processes, and since the TFT is the top-gate type TFT, it is not necessary to produce the light shielding layer, thus the manufacturing process is simple.

Although a few exemplary embodiments have been shown and described in reference to the accompanying drawings, it will be apparent to those skilled in the art that various modifications and changes may be made to these embodiments without departing from the principles and spirit of the present disclosure. Therefore, the scope of the disclosure should be defined by the appended claims and their equivalents.

## Claims

1. An array substrate, comprising:
a base substrate;
a thin film transistor on the base substrate; and
a photoelectric converter connected to a first electrode of the thin film transistor,
wherein the first electrode comprises a first conductive layer, the photoelectric converter is disposed on a side of the first conductive layer facing away from the base substrate, and the first conductive layer comprises a material resistant to etching in a process of forming the photoelectric converter, the first electrode is a source electrode or a drain electrode of the thin film transistor.

2. The array substrate according to claim 1, wherein a material of the first conductive layer comprises at least one of indium tin oxide, indium zinc oxide, indium gallium zinc oxide, indium tin zinc oxide, indium gallium tin oxide, zinc oxide, cadmium oxide, and aluminum oxide.

3. The array substrate according to claim 1, wherein the photoelectric converter further comprises a second conductive layer located on a second side of the photoelectric converter opposite to a first side, and the second conductive layer comprises metal material.

4. The array substrate according to any one of claims 1 to 3, wherein two ends of an active layer of the thin film transistor are respectively connected to the source electrode and the drain electrode of the thin film transistor, and an orthogonal projection of the active layer of the thin film transistor on the base substrate has a zigzag shape to lengthen a length between the two ends of the active layer.

5. The array substrate according to claim 4, wherein the orthogonal projection of the active layer of the thin film transistor on the base substrate has a U shape, and the source electrode and the drain electrode of the thin film transistor are respectively connected to the two ends of the active layer.

6. The array substrate according to claim 1, wherein the thin film transistor is a top-gate thin film transistor, the array substrate further comprises a second electrode connected to a transparent electrode layer, the transparent electrode layer being disposed on a surface of a side of the photoelectric converter facing away from the base substrate, an orthogonal projection of the second electrode on the base substrate and an orthographic projection of the active layer of the thin film transistor on the base substrate are spaced apart from each other.

7. The array substrate according to claim 6, wherein the array substrate further comprises a buffer layer between the active layer of the thin film transistor and the base substrate.

8. The array substrate according to claim 1, wherein the photoelectric converter is a photodiode.

9. The array substrate according to claim 1, wherein the thin film transistor is a low-temperature polysilicon thin film transistor.

10. A flat panel detector, comprising:
the array substrate according to any one of claims 1 to 9; and
a non-visible light conversion layer covering the array substrate,
wherein the non-visible light conversion layer is configured to convert non-visible light into visible light, and the photoelectric converter converts the visible light into an electrical signal.

11. An image apparatus comprising the flat panel detector of claim 10.

12. A method for manufacturing an array substrate, comprising following steps:
providing a base substrate;
forming a thin film transistor disposed on the base substrate, wherein the step of forming a thin film transistor comprises forming a first conductive material layer and forming a first electrode of the thin film transistor from the first conductive material layer through a patterning process; and
forming a photoelectric converter connected with the first electrode of the thin film transistor,
wherein the first electrode comprises a first conductive layer, the photoelectric converter is disposed on a side of the first conductive layer facing away from the base substrate, and the first conductive layer comprises a material resistant to etching in a process of forming the photoelectric converter.

13. The method according to claim 12, wherein a material of the first conductive layer comprises at least one of indium tin oxide, indium zinc oxide, indium gallium zinc oxide, indium tin zinc oxide, indium gallium tin oxide, zinc oxide, cadmium oxide, and aluminum oxide.

14. The method according to claim 12, further comprising:
forming a first metal material layer before forming the first conductive material layer,
wherein the first conductive material layer covers the first metal material layer, and the source electrode and the drain electrode of the thin film transistor are formed by implementing one patterning process on the first metal material and the first conductive material layer.

15. The method according to claim 12, wherein before forming the source electrode and the drain electrode, the method further comprises following steps:
forming a polysilicon material layer on the base substrate;
forming a U-shaped active layer through one patterning process;
forming a gate insulating layer and a second metal material layer; and
forming a gate electrode by performing one patterning process on the second metal material layer,
wherein an orthogonal projection of the gate electrode on the base substrate and an orthogonal projection of the U-shaped active layer on the base substrate have an overlapping region.

16. The method according to claim 12, wherein after forming the photoelectric converter, the method further comprises following steps:
forming a third metal material layer, and forming a second electrode connected to a transparent electrode layer through a patterning process, the transparent electrode layer being disposed on a surface of a side of the photoelectric converter facing away from the base substrate;
wherein an orthogonal projection of the second electrode on the base substrate and an orthogonal projection of the active layer of the thin film transistor on the base substrate are spaced apart from each other.

17. The method according to claim 15, wherein before forming the active layer, the method further comprises:
forming a buffer layer covering the base substrate on the base substrate.
